(19) Europäisches Patentamt
European Patent Office
Office européen des brevets

(11) Publication number: **0 110 322**
**A1**

(12) **EUROPEAN PATENT APPLICATION**

(21) Application number: **83111732.0**

(22) Date of filing: **23.11.83**

(51) Int. Cl.³: **C 09 C 3/00**, C 08 K 9/00
//
(C08K9/00, 9/02, 9/04, 9/06),
(C09C3/00, 3/06, 3/08, 3/12)

(30) Priority: **24.11.82 US 444269**

(43) Date of publication of application: **13.06.84**
**Bulletin 84/24**

(84) Designated Contracting States: **BE CH DE FR GB IT LI NL SE**

(71) Applicant: **Western Electric Company, Incorporated,**
**222 Broadway, New York, NY 10038 (US)**

(72) Inventor: **Sohn, John Edwin, 1937 Prospect Ridge Boulevard, Haddon Heights New Jersey 08035 (US)**

(74) Representative: **Blumbach Weser Bergen Kramer Zwirner Hoffmann Patentanwälte, Radeckestrasse 43, D-8000 München 60 (DE)**

(54) **Improved filler-polymer composites.**

(57) A composite material comprises filler particles in a polymeric matrix. The adhesion of the filler to the polymer is enhanced by coating the filler with a wetting hydrosol and a coupling agent prior to incorporation into the polymer.

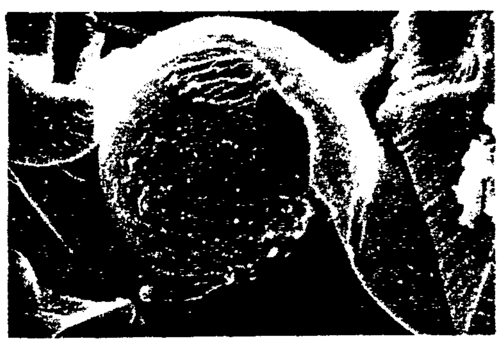

EP 0 110 322 A1

# IMPROVED FILLER-POLYMER COMPOSITES

## TECHNICAL FIELD

This invention relates generally to polymeric matrices incorporating inorganic fillers therein, e.g., in molding compounds. More particularly, this invention relates to filler-polymer systems suitable for use as substrates for printed circuit boards, hybrid integrated circuits or other related uses in the electronics industry.

## BACKGROUND OF THE INVENTION

Organic and inorganic fillers are often added to polymers to enhance the physical, mechanical or electrical properties of the polymer and/or to reduce the cost of the product. Poor adhesion between the filler particles and the polymer resin, however, often results in a decrease in mechanical strength of the composite. This is particularly true when attempting to obtain a composite having a high filler-to-matrix resin ratio. Consequently, a method for obtaining filler-polymer composites, especially with high filler loading, which will not fail mechanically due to lack of adhesion between the filler particles and the resin matrix is desirable.

Recently, L. Graham discovered, as set forth in U.S. Patent No. 4,362,783 issued December 7, 1982, that the adhesion between a substrate, e.g., a metal sheet, and a polymeric coating thereon could be enhanced by treating the substrate with a wetting hydrosol and a coupling agent. The present invention is a discovery that the technology set forth in Graham can be used to provide improved filler-polymer composites.

## SUMMARY OF THE INVENTION

An improved filler-polymer composite article comprises a polymeric matrix containing particulate filler material wherein the filler has been treated prior to incorporation in the polymer matrix so as to provide an adherent wetting hydrosol layer over the surface of the filler particles together with a coupling agent which

contains moieties which are compatible with the hydrosol and the polymeric resin with which the filler is to be mixed. The method of forming such articles is also included herein.

BRIEF DESCRIPTION OF THE DRAWINGS

FIG. 1 is a composite of three photomicrographs (a), (b) and (c) selected to illustrate interfacial failure (I), cohesive failure (C) and an intermediate failure mode (C/I); and

FIG. 2 is composite of four photomicrographs of the fracture surfaces of a glass bead filler in a silicone polymeric matrix showing both SNS treated and untreated, wet and dry factures.

DETAILED DESCRIPTION OF THE INVENTION

In general the invention involves the formation of a novel article comprising a filler-polymeric resin composite wherein the filler particles are precoated with a layer of a wetting hydrosol and a coupling agent thereover to enhance the adhesion of the filler to the polymeric matrix.

The filler material is typically an inorganic material such as an inorganic oxide or silicate or may be a metallic or other elemental material. Examples of typical inorganic fillers include glasses, silica, alumina, borosilicates, silicon, copper, talc, kaolin, mica and the like. However, organic fillers, e. g., Kevlar®, a polyamide made by E. I. DuPont may also be employed. The fillers, while usually used in the form of a powder, may also be provided as crystallites or fiber.

While in theory there is no limitation upon the particular polymeric matrix material employed in the composite, provided the coupling atent is compatible with it as set forth herein, typical polymer matrices which have been employed include epoxy resins, silicone resins, polystyrenes and polyimides.

A detailed discussion of wetting hyrosols suitable for use in accordance with this invention as well as their

manufacture can be found with reference to a patent issued to J. T. Kenney, U.S. Patent No. 3,657,003.

The preferred method for preparing the composite articles is as follows. The desired wetting hydrosol is prepared in accordance with the teachings in Kenney. The filler is added to the hydrosol and the mixture is stirred for several minutes at room temperature. The mixture is then filtered and the filler is washed with water until the filtrate is colorless. The wet filler is then added to a 1 weight percent aqueous solution of the coupling agent and the mixture is stirred for several minutes. The filler which then has a thin layer of hydrosol over its surface and a layer of coupling agent over the hydrosol is collected by filtration and dried, e.g., at about 120°C, for about 8-20 hours. The treated filler is then dispersed in the resin in one of two ways:

a) For resin systems which must be cured (i.e., uncured monomer, oligomer or prepolymer), the filler is added to the liquid resin systm (heating if necessary to make the system liquid) and stirred for about 1/2 hour. The curing agent is then added and the mixture stirred briefly. The mixture is then cast or otherwise processed into the desired form and cured; or

b) For systems which do not require curing (i.e., previously cured resin) the resin is dissolved in a suitable solvent to form a viscous solution. The filler is added to the resin solution and the mixture is stirred for about 1/2 hour to evently disperse the filler in the resin. The mixture is then cast or otherwise processed in the desired form and the solvent is allowed to evaporate. The composite is then baked at about 20°C above the boiling point of the solvent for about 8-20 hours to drive off excess solvent.

It was discovered that for the best results nonpolar or low polarity solvents are preferred. Also, it is preferred to wash the hydrosol treated filler particles prior to further treatment so as to leave essentially

a monomolecular layer of the hydrosol on the surface of the filler. Further, on the systems investigated, amine containing coupling agents are generally preferred. In order to determine the relative mechanical strength of filler-polymer composites, various composites were made using treated as well as untreated filler materials. Also, tests were run for comparison using fillers pretreated by prior art techniques. The various samples were tested by fracturing them under tension and then examining the fracture surface by means of scanning electron microscopy (SEM) to determine the polymer-to-filler adhesion upon fracture. Fracture tests were performed wet and dry. Wet tests were performed by first immersing the sample in water at 70°C for 24 hours and fracturing while wet. The tests results are noted based upon the predominant locus of failure as determined by the SEM study; C indicating a locus cohesive within the resin matrix; I indicating an interfacial locus; and C/I indicating both failure mechanisms observed with <50% interfacial fracture. On occasion observations were such that the locus of fracture was something less than cohesive wherein a C-C/I was demarked or where the locus was somewhat more cohesive than pure interfacial wherein I-C/I was demarked. The best adhesion between filler and matrix, of course, being indicated by a cohesive locus of fracture and the least adhesion by an interfacial locus of fracture.

The following tables set forth the fracture test results for various combinations of filler, polymer matrix and type of filler pretreatment under both wet (W) and dry (D) conditions. The shorthand notations utilized in these tables are as follows:

Resin

828-DTA-BDMA - is Shell Corp. Epon® 828 bisphenol A liquid epoxy resin together with diethylenetriamine (DTA) curing agent and benzyldimethylamine (BDMA) catalyst.

828-NMA-BDMA - is Shell Corp. Epon® 828 bisphenol A liquid epoxy resin together with nadic methyl anhydride

(NMA) curing agent and benzyldimethylamine (BDMA) catalyst.

828-X8-PIP - is the Epon® 828 resin modified by the addition of B. F. Goodrich Co.'s CTBN 1300X8 carboxy-terminated butadiene-acrylonitrile copolymer with piperidine as a curing agent.

828-PIP - is the Epon® 828 resin with piperidine.

438-BPA-BDMA - is Dow Corning's DEN 438 epoxy novolac resin together with bisphenol-A (BPA) crosslinker and BDMA. The polyimide employed is a thermoplastic polyimide.

<u>Fillers</u>

Kevlar® is an E. I. DuPont aromatic polyamide supplied in the form of fibers.

<u>Processing Steps</u>

SN refers to surface treatment of the filler particles with a wetting tin hydrosol only;

APS refers to surface treatment of the filler particles with p-aminophenyltrimethoxysilane,

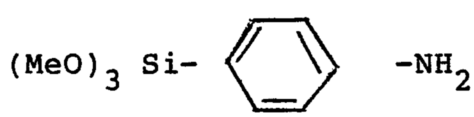

a coupling agent;

AEPS refers to surface treatment of the filler particles with N-2-aminoethyl-3-aminopropyltrimethoxysilane, $(MeO)_3\ Si-CH_2CH_2CH_2NHCH_2NH_2$, a coupling agent;

SN-APS refers to surface treatment of the filler particles first with the wetting tin hydrosol followed by treatment with APS coupling agent;

SNS refers to surface treatment of the filler particles first with the wetting tin hydrosol followed by treatment with the AEPS coupling agent;

Similarly, Fe-AEPS, Ce-AEPS and Tl-AEPS refer to treatment of the filler particles first with a wetting hydrosol selected from an iron hydrosol; a cerium hydrosol and a thallium hydrosol, respectively, followed by

treatment with AEPS.

It should be understood that the invention is not limited to the particular fillers, wetting hydrosols, coupling agents or polymers stated herein. It is possible, by selecting a wetting hydrosol from any of the many wetting hydrosols set forth in the aforementioned Kenney patent and a coupling agent from any of the many known materials employed as coupling agents, some of which are set forth in the Graham patent to obtain enhanced filler-polymer composites.

TABLE I

VARIOUS FILLERS IN A 438-BPA-BDMA RESIN MATRIX

TREATMENT

| Fillers | Untreated D | Untreated W | Sn D | Sn W | APS D | APS W | AEPS D | AEPS W | SN-APS D | SN-APS W | SNS D | SNS W |
|---|---|---|---|---|---|---|---|---|---|---|---|---|
| 29µm Na borosilicate spheres | C | I | C | I | C | C | C | C | C | I | C | C |
| ceramic hollow spheres | I | I | C | I | | | | | | | C | C/I |
| silica hollow glass spheres | | | C | C/I | | | C | C | | | C | C |
| Na borosilicate hollow glass spheres | C/I | I | C | I | | | C/I | I | | | C | C |
| alumina power | C | C | | | | | | | | | C | C |
| quartz powder | C/I | C/I | | | | | | | | | C | C |
| $BaTiO_3$ powder | C | C | | | | | | | | | C | C |
| mica flakes | I | I | I | I | | | C/I | C/I | | | I | I |
| Kevlar® fiber | | | | | | | | | | | C | C |

TABLE II

29µm SODIUM BOROSILICATE SPHERES

TREATMENT

| Resin System | Untreated D | Untreated W | Sn Treated D | Sn Treated W | APS Treated D | APS Treated W | AEPS Treated D | AEPS Treated W | Fe-AEPS Treated D | Fe-AEPS Treated W | Ce-AEPS Treated D | Ce-AEPS Treated W | Tl-AEPS Treated D | Tl-AEPS Treated W | SN-APS Treated D | SN-APS Treated W | SNS Treated D | SNS Treated W |
|---|---|---|---|---|---|---|---|---|---|---|---|---|---|---|---|---|---|---|
| 828-NMA-BDMA | | | | | | | | | C | I | C | C/I | C | C/I | | | | |
| 828-X8-PIP | | | | | | | | | | | | | | | | | | |
| Rm. Temp. | I | | | | | | | | | | | | | | | | I | |
| $LN_2$ Temp. | I | I | | | | | | | | | | | | | | | C | C |
| 828-PIP | C/I | I | | | | | | | | | | | | | | | C | C |
| 438-BPA-BDMA | C | I | C | I | C | C | C | C | | | | | | | C | I | C | C |
| polyethersulfone | C-C/I | | | | | | C-C/I | | | | | | | | | | C-C/I | |
| polystyrene | I | | | | I | I | I | | | | | | | | | | C | |
| polyetherimide | I | | | | | | I | | | | | | | | | | C | |
| silicone | I | I | | | | | I-C/I | | | | | | | | | | C | C |
| polyimide | I | | | | C/I | I | C | | | | | | | | | | C | |

TABLE III

KEVLAR® FIBER AND Cu POWDER IN VARIOUS POLYMER MATRICES

TREATMENT

| Filler | Polymer | Untreated D | Untreated W | SNS D | SNS W |
|---|---|---|---|---|---|
| Kevlar® | 828-DTA-BDMA | C | I | C | C-C/I |
| | 828-NMA-BDMA | C/I | C-C/I | C | C |
| | 438 BPA-DDMA | | | C | C |
| | polystyrene | C/I | C/I | C | C |
| | silicone | C | I-C/I | C | C |
| Copper | 828-DTA-BDMA | C | | C | |
| | 828-NMA-BDMA | I | | C | |

It can be seen that treating the fillers in accordance with the novel procedure, particularly when the given fillers are treated with a wetting tin hydrosol followed by treatment with AEPS coupling agent (the SNS process), adhesion of the filler to the polymer is generally enhanced.

As can be seen from FIG. 1 (a) and the untreated beads of FIG. 2, an interfacial failure or bond (I) is one showing little or no adhesion of the polymer matrix to the filler particles as evidenced by the clean surface of the particles and the separation of the particle surface from the surrounding polymer. In contrast to this is the cohesive failure or bond (C) depicted in FIG. 1 (b) and the SNS treated glass beads of FIG. 2 which shows good adhesion between the polymer matrix and the filler particles as evidenced by the polymer coated surface of the filler particles and absence of separation of the particle surface from the polymer. Intermediate to these failures is the failure designated C/I which shows in FIG. 1 (c) adhesion of polymer to only a portion of the fibrous filler particles.

It is to be understood that the above-described embodiments are simply illustrative of the principles of the invention. Various other modifications and changes may be devised by those skilled in the art which will embody the principles of the invention and all within the spirit and scope thereof.

Claims

1. A method of preparing a polymeric body having filler particles dispersed therein, comprising the steps of:

dispersing the dry filler particles in a liquid resin system;

forming the desired shape from the polymer having the filler particles dispersed therein; and

hardening the mass so as to form a solid polymeric body,

CHARACTERIZED IN THAT

to cause the filler particles to be cohesively bonded to the polymeric matrix of the body, the filler particles are subjected, prior to the dispersing step, to a following treatment:

(a) coating the surface of the filler particles with a wetting hydrosol which is adherent to the filler particles;

(b) washing the coated filler particles with water so as to leave essentially a monolayer of wetting hydrosol on the surface of said particles;

(c) coating the hydrosol coated filler particles with a layer of a coupling agent which is adherent to the hydrosol and to the polymeric matrix in which the particles are to be dispersed, and

(d) drying the coated filler particles;

2. The method according to claim 1,

CHARACTERIZED BY

using the filler in the form of powder, flakes or fiber.

3. The method according to claim 1 or 2,

CHARACTERIZED BY

selecting the filler from oxides, silicates, metals, minerals and organic particles, and the polymer from epoxies, silicones, polystyrenes and polyamides.

4. The method according to claim 1 or 2 or 3,

CHARACTERIZED IN THAT

the wetting hydrosol is a wetting tin oxide hydrosol and the coupling agent is silane.

5. The method according to claim 4, CHARACTERIZED IN THAT the coupling agent is an amine containing silane.

6. The method according to claim 4 or 5, the silane is N-2-aminoethyl-3-aminopropyltrimethoxysilane.

7. An article of manufacture including a polymer having filler particles dispersed therein, produced by the method according to any one of preceding claims 1-6, CHARACTERIZED IN THAT said filler particles have a coating thereon formed from treatment of the particles with a colloidal wetting hydrosol and a coupling agent thereover wherein the adhesion of the filler particle to the polymeric matrix is enhanced as compared with untreated filler particles of the same type dispersed in the same matrix.

FIG. I

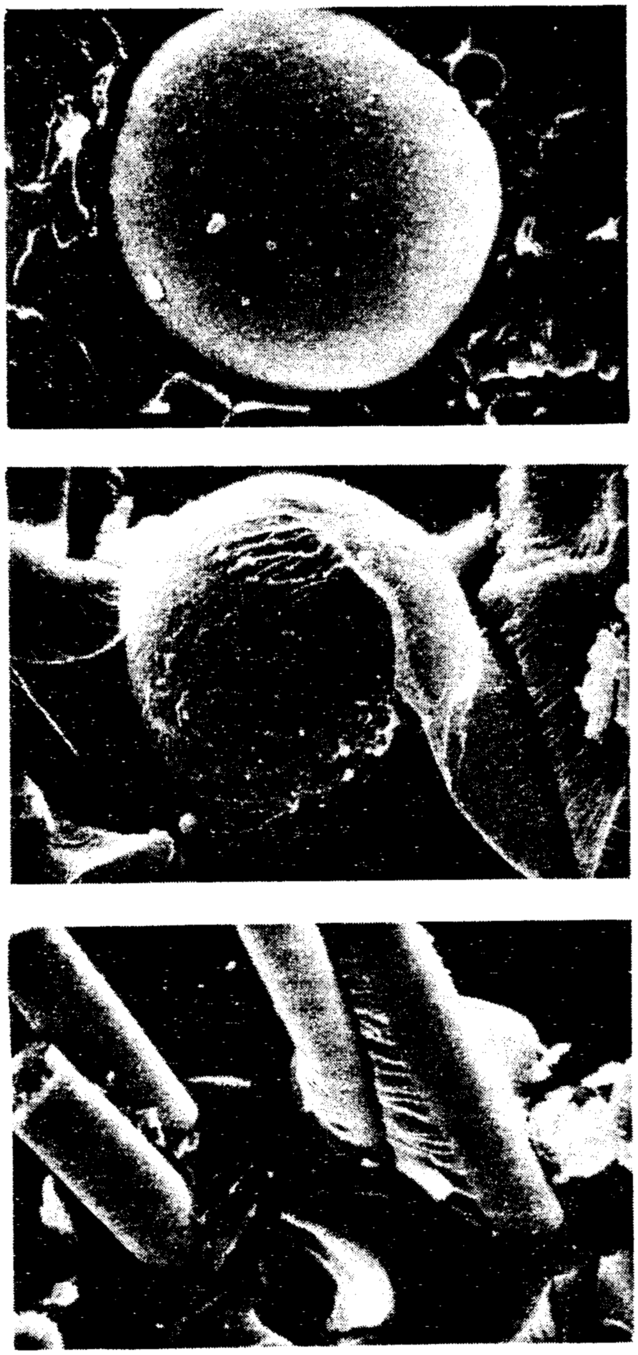

a

b

c

2/2

FIG. 2

GLASS BEADS/SILICONE

UNTREATED SNS TREATED

DRY

WET

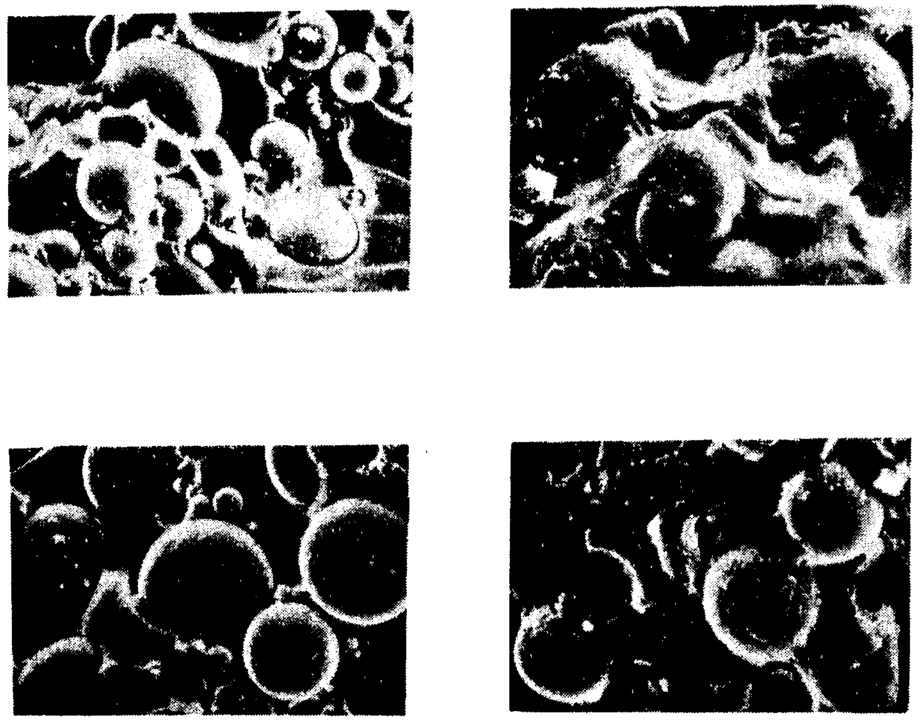

SEM PHOTOMICROGRAPHS OF FRACTURE SURFACES

European Patent Office

# EUROPEAN SEARCH REPORT

0110322 Application number

EP 83 11 1732

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| Y | DE-A-2 524 863 (UNION CARBIDE)<br>* Claims 1,2,6,7; page 23, lines 1-20 *<br>--- | 1-3,5-7 | C 09 C 3/00<br>C 08 K 9/00 //<br>(C 08 K 9/00<br>C 08 K 9/02<br>C 08 K 9/04<br>C 08 K 9/06 )<br>(C 09 C 3/00<br>C 09 C 3/06<br>C 09 C 3/08<br>C 09 C 3/12 ) |
| Y | GB-A-2 082 478 (WESTERN ELECTRIC)<br>* Claims *<br>--- | 1-7 | |
| X | DE-A-2 039 170 (DOW CORNING)<br>* Claims *<br>--- | 1-3,5-7 | |
| A,D | US-A-3 657 003 (J. KENNEY)<br>* Columns 13-20 *<br>----- | | TECHNICAL FIELDS SEARCHED (Int. Cl. 3)<br>C 08 K<br>C 09 C |

The present search report has been drawn up for all claims

| Place of search | Date of completion of the search | Examiner |
|---|---|---|
| THE HAGUE | 27-02-1984 | HOFFMANN K.W. |

CATEGORY OF CITED DOCUMENTS

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons

& : member of the same patent family, corresponding document

EPO Form 1503. 03.82